Europäisches Patentamt

(19) European Patent Office

Office européen des brevets

(11) Publication number: **0 176 714 B1**

## EUROPEAN PATENT SPECIFICATION

(45) Date of publication of patent specification: **06.03.91** (51) Int. Cl.5: **H01L 29/78, G11C 11/00**

(21) Application number: **85110140.2**

(22) Date of filing: **13.08.85**

(54) Memory cell storing logic data in volatile and non-volatile forms.

(30) Priority: **27.09.84 US 655176**

(43) Date of publication of application:
**09.04.86 Bulletin 86/15**

(45) Publication of the grant of the patent:
**06.03.91 Bulletin 91/10**

(84) Designated Contracting States:
**DE FR GB**

(56) References cited:
**EP-A- 0 081 626**
**EP-A- 0 083 418**

**IBM TECHNICAL DISCLOSURE BULLETIN, vol. 22, no. 6, November 1979, pages 2403-2404, New York, US; C.R. HOFFMAN: "Floating gate nonvolatile memory cell"**

(73) Proprietor: **International Business Machines Corporation**
**Old Orchard Road**
**Armonk, N.Y. 10504(US)**

(72) Inventor: **Lam, Chung Hon**
**Apt. 5-2 Nott Drive**
**Troy, N.Y. 12181(US)**

(74) Representative: **Rudack, Günter O., Dipl.-Ing.**
**IBM Corporation Säumerstrasse 4**
**CH-8803 Rüschlikon(CH)**

## Description

The invention relates generally to the field of non-volatile dynamic random access memory cells.

Non-volatile floating-gate metal-oxide-silicon(MOS) memories are well known in the industry. In such devices, the conductive state of the transistor memory cell is determined by the voltage on an associated floating gate.

Designs have been proposed which facilitate the erasure and resetting of the voltages on these floating gates. For example, in US-A-4,119,995, the floating gate is controlled by separate programming and erasure gates which are disposed above the floating gate and insulated therefrom by an oxide layer. The floating gate voltage is programmed by electron injection from the substrate. The charge on the floating gate is erased by causing electrons to flow from the floating gate up to the erasing gate.

Other designs have been proposed which utilize charge transfer between the floating gate and one or more control gates to both erase and program the floating gate (i.e., in these designs the tunnelling or avalanche of electrons from a structure other than a substrate region is used to set the voltage of the floating gate). See e.g. Lee, "A New Approach for the Floating-Gate MOS Nonvolatile Memory", Applied Physics Letters, Vol. 31, No. 7, October 1977, pp. 475-476. This paper discloses a single control gate separated from the floating gate by a poly-oxide layer. When the control gate is biased positive for writing, electron flow is induced from the floating gate to the control gate. Since this flow is greater than the flow of electrons from the substrate to the floating gate, the floating gate accumulates positive charge. When the control gate is ramped negative to erase, the floating gate accumulates negative charge. See also US-A-4,099,196, US-A-4,274,012, US-A-4,300,212 and US-A-4,314,265 which disclose erasable PROM's wherein a programming gate is disposed below the floating gate and an erasure gate is disposed above the floating gate. The devices are programmed by inducing electron flow from the program gate to the control gate and are erased by inducing electron flow from the floating gate to the erasing gate. In all three patents, the surface of one or more of the gates is roughened in order to enhance the induced electric fields. This promotes electron flow through the oxide layers separating the gates.

Among the materials which have charge injection properties is the so-called dual electron injector structure (DEIS), which is a layer of $SiO_2$ having excess silicon crystals on its upper and lower surfaces. This structure is disclosed in US-A-4,104,675. DEIS is generally formed by a chemical vapor deposition process which induces extra silicon crystal growth both prior and subsequent to the formation of an otherwise normal $SiO_2$ layer. Several patents specifically disclose the use of a DEIS layer as the injector structure for a non-volatile memory. See e.g., US-A4,336,603. This patent discloses a single control gate which injects electrons into the floating gate through a DEIS layer.

This DEIS layer has also been incorporated in providing the injector structure for the non-volatile component of a non-volatile dynamic RAM. See e.g., US-A-4,446,535 which discloses the use of DEIS to construct a single control gate of a non-volatile element associated with (i.e. storing the "latent image" of) a dynamic RAM cell (DRAM). Such non-volatile DRAMs are also disclosed in US-A-4,449,205, US-A-4,363,110, US-A-4,432,072, and US-A-4,375,085. In each of these patents, the data stored on the floating gate is erased before new data can be stored thereon. This extra operational step adversely affects the operational speeds attainable in these memories.

It is an object of the present invention to provide an improved non-volatile dynamic random access memory cell.

It is another object of the invention to provide a non-volatile dynamic memory cell in which data can be written into the cell without first erasing the existing data stored therein.

It is yet another object of the invention to provide a non-volatile dynamic RAM cell which needs a minimum of support circuitry.

These and other objects of the invention are realized by a non-volatile dynamic RAM cell in which the plate of the storage capacitor is coupled through a layer of DEIS material to an associated floating gate electrode. The floating gate is also coupled to a control gate electrode through a separate layer of DEIS material.

In operation, when a first binary logic state is written into the floating gate from the storage capacitor, the DEIS material induces electron flow from the floating gate to the control gate. When a second binary logic state is written into the floating gate, the DEIS material induces charge injection from the plate of the capacitor into the floating gate. Due to the characteristics of the DEIS layer, the above-described charge transfers will occur if the logic state to be written is the opposite of the logic state already stored on the floating gate. No charge transfer will occur if these logic states are the same. Hence, there is no need for an erasure step prior to writing a given logic state into the non-volatile portion of the non-volatile dynamic RAM of the invention.

The foregoing and other objects, features and advantages of the present invention will become more apparent from the following detailed description of one embodiment of the invention. In the description to follow, reference will be made to the accompanying drawings, in which:

Fig. 1 is a cross-sectional view of the memory cell of the invention;

Figs. 2A and 2B are schematic diagrams illustrating the conductive characteristics of the DEIS layer; and

Fig. 3 is an equivalent circuit of the memory cell of the invention.

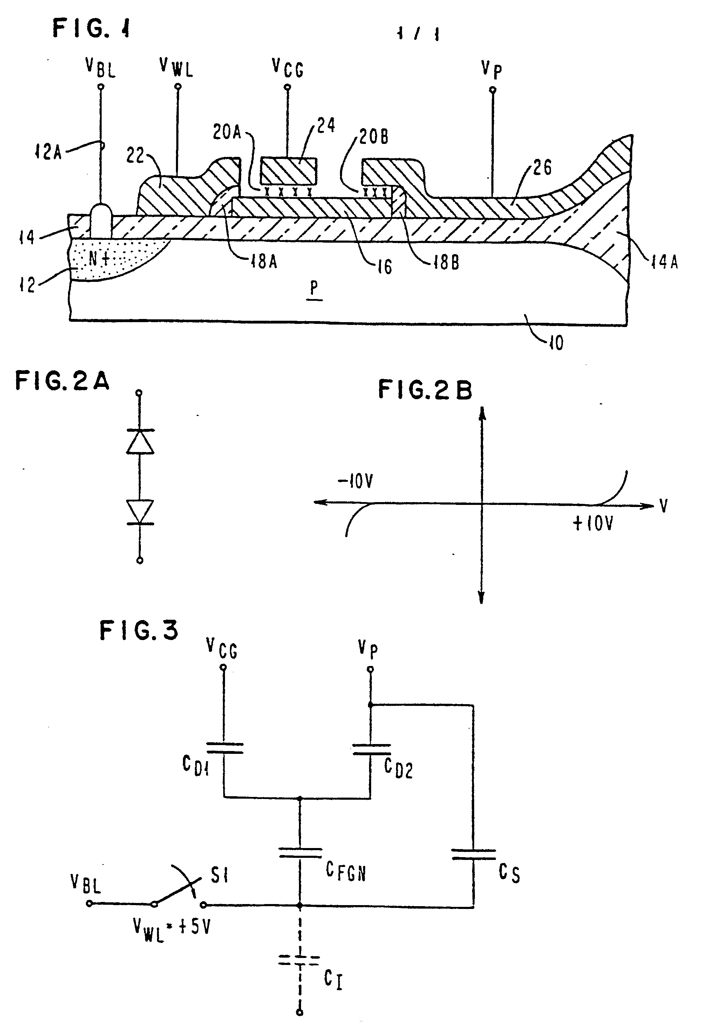

With reference to Fig. 1, the structure of the memory cell will be described. A p-type substrate 10 has an n-type diffusion 12 formed therein via typical ion implantation techniques. Note that these conductivity types are given by way of example; e.g., substrate 10 could be made of p-type silicon. The n-type region 12 constitutes a diffused bit line which is connected through a connector 12A to a bit line voltage source. Substrate 10 is covered by an oxide layer 14. An isolation region (ROX) 14A is grown during the step, using conventional techniques. Insulator layer 14 is then covered by a first polycrystalline silicon layer, which is etched to form a floating gate electrode 16. A layer of DEIS material 20 is then formed on top of floating gate 16 using the techniques previously discussed. Note that the DEIS layer 20 is only formed on the upper surface of floating gate 16; the sides of the floating gate are oxidized to form conventional oxide layers 18A and 18B, respectively.

A second layer of polycrystalline silicon is deposited on the substrate. The second polysilicon layer and the DEIS layer are etched (using conventional techniques) to form a word line electrode 22, a first control gate including a control gate electrode 24 and a first underlying DEIS region 20A, and a second control gate including a capacitor plate 26 and a second underlying DEIS region 20B. Note that only a portion of capacitor plate 26 overlies DEIS region 20B; the remainder of plate 26 overlies insulator layer 14 to form a conventional dynamic RAM storage capacitor. The word line electrode 22 receives a control voltage $V_{WL}$ and acts as a switch in transferring the bit line voltage to the memory cell. The control gate electrode receives a voltage $V_{CG}$ for controlling the voltage state of floating gate 16. Finally, the capacitor plate 26 receives a control voltage $V_P$ which aids in controlling both the voltage on the storage capacitor $C_S$ and the voltage state of floating gate 16.

In Fig. 1, the size of the portion of storage plate 26 which overlays the floating gate appears to be equivalent to that of the control gate electrode 24. In practice, however, the control gate electrode 24 is larger than (i.e. elongated with respect to) the portion of storage plate 26 which overlays the floating gate. This size difference effects the respective capacitance of the respective control gates, as will be discussed in more detail below.

Prior to discussing the operation of the cell, the characteristic of the DEIS layer will now be reviewed. Due to the electron flow enhancement properties of the surfaces of the DEIS layer with respect to the inner $SiO_2$, each surface of the DEIS layer has an inherent diode characteristic. Since the respective surfaces of the DEIS layer promote electron flow in different directions, the total DEIS layer acts as (i.e. provides the electrical characteristic of) two back-to-back connected diodes, as shown in Fig. 2A. As shown in Fig. 2B, it is preferred that the DEIS layer be formed such that these diodes begin conduction at approximately ±10 volts. Thus, while the use of DEIS material is preferred, any sort of charge injector material or structure can be used which exhibits the above-described characteristics.

The operation of the invention will now be described with reference to Fig. 3, which shows an equivalent circuit of the cell of Fig. 1. Switch S1 represents the word line FET, which switches $V_{BL}$ onto the substrate when $V_{WL}$ goes to +5 volts. $C_{D1}$ is the capacitance formed by DEIS region 20A between control gate electrode 24 and floating gate 16; $C_{D2}$ is the capacitance formed by DEIS region 20B between polysilicon capacitor plate 26 and floating gate 16; $C_{FGN}$ is the capacitance formed by insulator layer 14 between floating gate 16 and the substrate 10; $C_I$ is an additional inversion capacitance formed between the floating gate 16 and the substrate 10 only when a well region is induced beneath floating gate 16; and $C_S$ is the storage capacitor. For the sake of clarity, the various parasitic capacitances inherent in the memory cell have been deleted from the equivalent circuit of Fig. 3. This equivalent circuit has been found to present a first order approximation of the performance of the memory cell.

Prior to describing the non-volatile aspects of the operation of the memory cell of the invention, a brief discussion will now be made of its function as a dynamic memory device. To write volatile data into the cell, $V_P$ is set at +5 volts. The control gate voltage $V_{CG}$ is set at +8 volts, which causes the floating gate voltage $V_{FG}$ to rise to ~ +5 volts (due to the respective capacitive values of $C_{D1}$, $C_{D2}$ and $C_{FGN}$, as will be discussed in more detail later). After the voltage on the floating gate has stabilized, $V_{WL}$ is ramped up to +5 volts, causing the bit line voltage to be transferred via the word line device to the storage capacitor $C_S$. If $V_{BL}$ = 0 volts, the storage capacitor will be grounded and will thus store a "0" logic state; if $V_{BL}$ = +5 volts, $C_S$ will charge to +5 volts minus Vt (the threshold of the word line device) and will thus store a "1" logic state. To read the cell, the bit line is precharged to +5V, $V_{WL}$ is again ramped to +5 volts, and the bit line current is sensed. If the storage capacitor is storing a "0", the capacitor will charge and hence the bit line current will drop. If the capacitor is storing a "1", there will not be any bit line drop. Thus, the surface of the substrate beneath the floating gate and the capacitive plate functions as a dynamic storage node.

The relationships between the capacitances of the capacitors shown in Fig. 3 are as follows:

$$C_{D1} \cong 1/2\ C_{FGN}$$
$$C_{D2} \cong 1/3\ C_{D1}$$
$$C_I \cong 0.1\ C_{FGN}$$
$$C_S > C_{FGN}$$

These general relationships govern the operation of the cell by controlling the charge transfer through DEIS regions 20A and 20B, as will be discussed in more detail below. The difference between the capacitances of $C_{D1}$ and $C_{D2}$ is caused by the above-mentioned difference in the respective sizes of control gate 24 and the portion of capacitor plate 26 overlying DEIS region 20B.

The non-volatile aspects of the operation of the cell will now be discussed for "SAVE" and "GET" operations. The "SAVE" operation causes each of the floating gates of the memory array to store the logic states on its associated storage capacitor. The "GET" operation causes all of the floating gates to transfer its stored logic state to its associated storage capacitor. This enables the memory array to be written into and read from in the same manner as conventional dynamic storage cells (since these operations are carried out with respect to the storage capacitor and not the floating gate). It is important to note that both operations are non-destructive with respect to the transferor (e.g. after the "SAVE" operation, the capacitor still retains its stored logic state).

To perform the "SAVE" operation, $V_{WL}$ is forced to ground, $V_{BL}$ is set at +5 volts and the voltage on the control gate electrode is raised from +8.5 volts to +20 volts. After $V_{CG} = 20V$, the voltage $V_P$ on the capacitor plate is lowered to ground. As a consequence, the potential well beneath floating gate 16 increases, and the potential well beneath capacitor plate 26 decreases. If the capacitor is storing a "0" state (i.e. no charge being stored), the inversion layer beneath the capacitor plate has its normal complement of electrons. Thus, when the potential well beneath the capacitor decreases in size, electrons will be forced to flow from beneath the capacitor plate to the larger potential well beneath the floating gate. This causes the surface of the substrate beneath the floating gate to become more negatively charged, capacitively coupling the floating gate voltage $V_{FG}$ towards ground potential. If the capacitor is storing a "1" state (i.e. +5V charge storage), the inversion layer beneath the plate is depleted of free electrons. No charge transfer to the potential well beneath the floating gate takes place, allowing the floating gate voltage to vary with the control gate voltage (which is at a high level).

In general, the voltage on the floating gate can be expressed as

$$V_{FG} = \chi V_{CG}, \tag{1}$$

where $\chi$ is the capacitor coupling ratio. When a "0" is to be stored, $V_{CG} = +20V$, $V_P = 0V$ and $V_{FG} = 0V$, such that

$$\chi_{"0"} = \frac{C_{D1}}{C_{FGT"0"}} \tag{2}$$

where

$$C_{FGT"0"} \cong C_{D1} + C_{D2} + C_{FGN} \tag{3}$$

Assume that $\chi_{"0"} \cong 0.3$ ; thus $V_{FG} = 0.3 \bullet (20) = +6.0$ volts. Now referring back to Fig. 2B, we see that the DEIS material will conduct where the difference between either $V_{CG}$ and $V_{FG}$ or $V_P$ and $V_{FG}$ is greater than 10 volts. In this situation, $V_{CG}\text{-}V_{FG} = 20\text{-}6 = 14$ volts. Thus, DEIS region 20A associated with control gate electrode 24 will conduct, removing charge from floating gate 16 and injecting the charge into control gate electrode 24. This charge transfer will continue until the voltage on the floating gate rises from +6.0V to 10 volts. The net charge gain by the floating gate can be expressed as

$$Q_{FG"0"} = (V_{FGf} - V_{FGi}) \, C_{FGT"0"} \qquad (4)$$

where $V_{FGi} = +6V$ and $V_{FGf} = +10V$. Thus, the potential due to the floating gate charge is $Q_{FG"0"}/C_{FGT} = +4V$, since $C_{FGT} = C_{FGT"0"}$.

If a "1" is to be stored, recall that the inversion layer beneath the floating gate is floating due to a lack of electron flow from the inversion layer of the storage capacitor. This creates a depletion capacitance $C_I$ between the floating gate capacitor $C_{FGN}$ and the substrate. Thus,

$$X_{"1"} \cong \frac{C_{D1}}{C_{D1} + C_{D2} + \dfrac{(C_{FGN})(C_I)}{C_{FGN} + C_I}}, \qquad (5)$$

Assuming $X_{"1"} \cong 0.7, V_{FG} = 0.7 \bullet (20) = +14$ volts. Thus, with reference to Fig. 2B, it is apparent that -4.0 volts of charge will be injected into the floating gate by the capacitor plate 26 via DEIS region 20B. Again, the net charge gain by the floating gate is $Q_{FG"1"} = (V_{FGf} - V_{FGi}) \, C_{FGT"1"}$ where

$$C_{FGT"1"} \cong C_{D1} + C_{D2} + \frac{(C_{FGN})(C_I)}{C_{FCN} + C_I}, \qquad (6)$$

and the final potential of the floating gate due to this charge is $Q_{FG"1"}/C_{FGT} = -4$ volts.

Thus, the floating gate will store a +4V charge when storing a "0" and a -4V charge when storing a "1".

A feature of disclosed memory cell is that the dynamically stored data can be read (by the coupling of the data signals to the storage capacitor) without concern that the negatively charged floating gage will impede channel formation. As discussed above, the charge on the floating gate is -4V when storing a "1" state. This high negative charge may be sufficient to at least partially decouple the voltage developed on the bit line from the storage capacitor by prohibiting channel formation. However, when we want to "read" the logic state stored on the capacitor and the floating gate stores a "1", the depletion capacitance $C_I$ will be removed since the inversion layer beneath the floating gate no longer floats (i.e. it is receiving electrons from the word line device). As a result, the voltage due to the stored charge will drop from -4V ($= Q_{FG}/C_{FGT"1"}$) to -1.8V ($= Q_{FG}/C_{FGT"0"}$), and thus the floating gate will not impede channel formation to a degree which would prevent a proper "read" cycle.

The foregoing description of the non-volatile operation of the cell was made with the assumption that the floating gate was devoid of charge when the writing operation was initiated. A feature of the invention is that new data can be written over the old data stored on the floating gate without the need for an intervening erasure of the old data. This feature will now be discussed in more detail. During the discussion, reference will be made to the following relationship:

$$V_{FGN} = V_{FGO} + V_{FGW}$$

where

$V_{FGN} =$ the new voltage of the floating gate at the end of the present writing step;

$V_{FGW} =$ the voltage on the floating gate at the end of the present writing step, assuming no previous floating gate charge; and

$V_{FGO} =$ the voltage on the floating gate due to the previous charge storage from an immediately preceding writing step.

(a) Cell at "0" state, write in a "0":

Under these circumstances, the voltage on the floating gate $V_{FGN} = (+6V) + (+4V) = +10$ volts. That is, assuming no previous charge storage, the floating gate will be at +6 volts when storing a "0"; furthermore, due to the charge transfer in storing a prior "0", the floating gate already has +4.0 volts of charge stored thereon. Therefore, since the floating gate is at +10 volts, there will not be any charge injection, and the voltage on the floating gate will still be +4 volts.

(b) Cell at "1" state, write in a "0":

Here, $V_{FGN}$ = (-4V) + (+6V) = +2V. The -4 volts is due to the charge injected on the floating gate in storing a "1" previously, and the +6V is due to the present writing of a "1". Thus, there will be +8 volts worth of charge removal from the floating gate to control gate electrode 24, and the final voltage of the floating gate will be $V_{FG}$ = (-4V) + (+8V) = +4V.

(c) Cell at "0" state, write in a "1":

Initially, $V_{FGN}$ = (+4V) + (+14V) = +18 volts, such that -8V worth of charge will be injected into the floating gate and $V_{FG}$ = (+4.5) + (-8V) = -4 volts.

(d) Cell at "1" state, write in a "1":

$V_{FGN}$ = (-4V) + (+14V) = +10 volts, such that no charge injection occurs and $V_{FG}$ still = -4 volts.

Once the above-described "SAVE" operation has been completed, the charge on the floating gate is indicative of the logic state on the storage capacitor. Since the charge stored on the capacitor is no longer important, the memory array does not have to be periodically refreshed. In order to read the cell by conventional DRAM techniques, the charge stored on the floating gate must now be transferred back to the storage capacitor. In this "GET" operation, a "1" is first written into all of the cells of the array by raising the bit line voltage $V_{BL}$ to +5 volts and then raising the word line voltage $V_{WL}$ to +5 volts, while keeping $V_{CG}$ = 8.5V and $V_P$ at +5 volts. As a result, the storage capacitor will be charged to +5V - $V_T$ of the word line device. Note that this step can be completed concurrently with a conventional DRAM refresh cycle by forcing the bit line to +5V.

Then, the control electrode 24 is grounded ($V_{CG}$ = 0), the bit line is grounded ($V_{BL}$ = 0), and then the word line 22 is raised to +5 volts. The floating gate potential is due only to the charge stored on the floating gate. If the floating gate is positively charged (i.e. storing a "0" state), a channel will be induced below the floating gate, and the voltage of the inversion layer beneath the capacitor will be forced to the bit line voltage (i.e. ground). Hence, for a "0" stored on the floating gate, the capacitor voltage is at ground after the "GET" operation. On the other hand, for a stored "1", the negative charge on the floating gate will prohibit channel formation, and hence the inversion layer of the capacitor will remain at +5 volts after the "GET" operation. Again, this step can be concurrent with a conventional DRAM refresh cycle by forcing the bit line to 0V.

The non-volatile dynamic memory of the invention can be implemented with a minimum of support circuitry. Only one control voltage ($V_{CG}$) rises above $V_{DD}$ = +5 volts. Moreover, the memory cell of the invention is of relatively simple construction, and hence does not require a large number of processing steps in order to construct.

Further, the non-volatile portion of the memory cell has an overwrite capability. That is, new data can be written into the floating gate without first erasing the previously stored logic state. This elimination of the intervening erase step improves the overall storage cycle time of the cell.

## Claims

1. Memory cell storing logic data in volatile and non-volatile forms, the non-volatile storage having an overwrite capability, comprising a semiconductor substrate having a first region of a first conductivity type, said first region functioning as a dynamic storage node, and a second region of a second conductivity type formed on said first region, a transfer device for coupling first control signals from said second region to said first region, and a floating gate electrode disposed above and insulated from a portion of said first region, characterized by first and second charge injection means (20A, 20B) disposed on said floating gate electrode (16) for injecting charge into and removing charge from said floating gate electrode (16) and first and second control gate electrodes (24, 26) disposed on said first and second charge injection means (20A, 20B), respectively, said first and second control gate electrodes (24, 26) receiving second and third control signals ($V_{CG}$, $V_P$), respectively, such that either one of said charge injection means (20A, 20B) injects charge into said floating gate electrode (16), or the other of said charge injection means (20A, 20B) removes charge from said floating gate electrode (16), as a function of the logic state of said dynamic storage node, whereby said first and second charge injector means (20A, 20B) are prohibited from performing either said charge injection or said charge removal when the logic state to be stored by said floating gate electrode (16) is the same as the logic state currently stored thereon.

2. Memory cell in accordance with claim 1, characterized in that said second region (12) of said substrate (10, 12) is designed as a diffused bit line receiving data signals ($V_{BL}$) from a data signal source.

3. Memory cell in accordance with claim 2, characterized in that said transfer device (22) is designed as a word line insulated from and overlying said semiconductor substrate (10, 12).

4. Memory cell in accordance with claim 1, characterized in that said floating gate electrode is composed of a first layer (16) of polycrystalline silicon, and that said first and second control gate electrodes (24, 26) comprise a second layer (20A, 20B) of polycrystalline silicon.

5. Memory cell in accordance with claim 1, characterized in that said word line electrode (22) is composed of a layer of polycrystalline silicon.

6. Memory cell in accordance with claim 1, characterized in that each of said first and second charge injection means (20A, 20B) has an electrical characteristic analogous to that of two back-to-back connected diodes.

7. Memory cell in accordance with claim 6, characterized in that each of said charge injection means comprises a layer of a double electron injector structure material which has been etched to form two separate regions (20A, 20B).

8. Memory cell in accordance with claim 1, characterized by a storage plate electrode (26) disposed on and insulated from said semiconductor substrate (10, 12), said storage plate electrode (26) at least partially overlying said first region (10).

9. Memory cell in accordance with claim 8, characterized in that said storage plate electrode (26) and one of said first and second control gate electrodes (24, 26) are electrically in common.

10. Memory cell in accordance with claim 1, characterized in that said first and second control gate electrodes (24, 26) receive first and second control signals ($V_{CG}$, $V_P$) respectively, said first control gate electrode (24) removing charge from said non-volatile storage means (16) when said first region (10) of said substrate (10, 12) is storing a first voltage indicative of a first logic state, and said second control gate electrode (26) injecting charge into said non-volatile storage means (16) when said first region (10) of said substrate (10, 12) stores a second voltage indicative of a second logic state.

**Revendications**

1. Cellule de mémoire stockant des données logiques sous forme volatile et sous forme non volatile, la mémoire non volatile ayant une possibilité d'écriture en superposition, comprenant un substrat semi-conducteur ayant une première région d'un premier type de conductivité, ladite première région fonctionnant comme un noeud de stockage dynamique, et une deuxième région d'un deuxième type de conductivité formée sur ladite première région, un dispositif de transfert pour le couplage de premiers signaux de commande de ladite deuxième région à ladite première région, et une électrode de grille flottante disposée au-dessus et isolée d'une partie de ladite première région, caractérisée en ce que des premier et deuxième moyens d'injection de charge (20A,20B) sont disposés sur ladite électrode de grille flottante (16) pour injecter une charge et enlever une charge vers et à partir de ladite électrode de grille flottante (16) et d'une première et d'une deuxième électrodes de grille de commande (24,26) disposées sur lesdits premier et deuxième moyens d'injection de charge (20A,20B), respectivement, lesdites première et deuxième électrodes de grille de commande (24,26) recevant des deuxième et troisième signaux de commande ($V_{CG}$, $C_P$), respectivement, de sorte que l'un quelconque desdits moyens d'injection de charge (20A,20B) injecte une charge dans ladite électrode de grille flottante (16), ou que l'autre desdits moyens d'injection de charge (20A,20B) enlève de la charge de ladite électrode de grille flottante (16), en fonction de l'état logique dudit noeud de stockage dynamique, lesdits premier et deuxième moyens d'injection de charge (20A, 20B) étant ainsi empêchés d'effectuer ladite injection de charge ou ledit enlèvement de charge lorsque l'état logique à mémoriser par ladite électrode de grille flottante (16) est le même que l'état logique présentement mémorisé sur cette dernière.

2. Cellule de mémoire suivant la revendication 1, caractérisée en ce que ladite deuxième région (12) du dit substrat (10,12) est conçue comme une ligne de bit diffusée recevant des signaux de données ($V_{BL}$) provenant d'une source de signaux de données.

3. Cellule de mémoire suivant la revendication 2, caractérisée en ce que ledit dispositif de transfert (22) est conçu comme une ligne de mot isolée dudit substrat semi-conducteur (10,12) et superposée à celui-ci.

4. Cellule de mémoire suivant la revendication 1, caractérisée en ce que ladite électrode de grille flottante est composée d'une première couche (16) de silicium polycristallin, et en ce que lesdites première et deuxième électrodes de grille de commande (24,26) comprennent une deuxième couche (20A,20B) de silicium polycristallin.

5. Cellule de mémoire suivant la revendication 1, caractérisée en ce que ladite électrode de ligne de mot (22) est composée d'une couche de silicium polycristallin.

6. Cellule de mémoire suivant la revendication 1, caractérisée en ce que chacun desdits premier et deuxième moyens d'injection de charge (20A,20B) possède une caractéristique électrique analogue à celle de deux diodes connectées dos à dos.

7. Cellule de mémoire suivant la revendication 6, caractérisée en ce que chacun desdits moyens d'injection de charge comprend une couche d'une matière à structure de double injection d'électrons qui a été attaquée pour former deux régions séparées (20A,20B).

8. Cellule de mémoire suivant la revendication 1, caractérisée par une électrode de plaque de stockage (26) disposée sur ledit substrat semi-conducteur (10, 12) et isolée de celui-ci, ladite électrode de plaque de stockage (26) étant au moins partiellement superposée à ladite première région (10).

9. Cellule de mémoire suivant la revendication 8, caractérisée en ce que ladite électrode de plaque de stockage (26) et une desdites première et deuxième électrodes de grille de commande (24,26) sont électriquement en commun.

10. Cellule de mémoire suivant la revendication 1, caractérisée en ce que lesdites première et deuxième électrodes de grille de commande (24,26) reçoivent des premier et deuxième signaux de commande ($V_{CG}$, $V_P$), respectivement, ladite première électrode de grille de commande (24) enlevant la charge desdits moyens de stockage non volatil (16) lorsque ladite première région (10) dudit substrat (10,12) stocke une première tension indicative d'un premier état logique, et ladite deuxième électrode de grille de commande (26) injectant une charge dans lesdits moyens de stockage non volatil (16) lorsque ladite première région (10) dudit substrat (10,12) stocke une deuxième tension indicative d'un deuxième état logique.

## Ansprüche

1. Speicherzelle zum Speichern logischer Daten in flüchtiger und nichtflüchtiger Weise, wobei der nichtflüchtige Speicher die Fähigkeit zum Überschreiben besitzt, mit einem Halbleitersubstrat mit einer ersten Zone eines ersten Leitfähigkeitstyps, die als dynamischer Speicherknoten wirkt, und mit einer auf der genannten ersten Zone angeordneten zweiten Zone eines zweiten Leitfähigkeitstyps, mit einer Übertragungsvorrichtung für das Einkoppeln erster Steuersignale von der genannten zweiten Zone in die genannte erste Zone, und mit einer auf der genannten ersten Zone isoliert angeordneten schwebenden Gate-Elektrode, *gekennzeichnet* durch erste und zweite Ladungsträger-Injektionsmittel (20A, 20B), die auf der genannten schwebenden Gate-Elektrode (16) angeordnet sind, um in diese Ladung zu injizieren oder aus ihr Ladung abzuführen, und erste und zweite auf den genannten ersten und zweiten Ladungsträger-Injektionsmitteln (20A, 20B) angeordnete Steuerelektroden (24, 26), die zweite bzw. dritte Steuersignale ($V_{CG}$, $V_P$) empfangen, wodurch entweder das eine oder das andere der Ladungsträger-Injektionsmittel (20A, 20B) eine Ladung in die genannte schwebende Gate-Elektrode (16) injiziert, oder das betreffende andere der Ladungsträger-Injektionsmittel (20A, 20B) von der schwebenden Gate-Elektrode (16) als Funktion des logischen Zustandes des genannten dynamischen Speicherknotens Ladung abführt, wobei den ersten und zweiten Ladungsträger-Injektionsmitteln (20A, 20B) verboten ist, eine Ladungsträger-Injection oder eine Ladungsabführung vorzunehmen, wenn der von der schwebenden Gate-Elektrode (16) zu speichernde logische Zustand der gleiche ist, wie der darin gerade gespeicherte.

2. Speicherzelle gemäß Anspruch 1, dadurch *gekennzeichnet*, daß die genannte zweite Zone (12) des Substrats (10, 12) als diffundierte Bitleitung ausgebildet ist, die Datensignale ($V_{BL}$) von einer Datensi-gnalquelle empfängt.

3. Speicherzelle gemäß Anspruch 2, dadurch *gekennzeichnet*, daß die genannte Übertragungsvorrichtung (22) als Wortleitung ausgebildet ist, die auf dem Halbleitersubstrat (10, 12), aber von diesem isoliert, angeordnet ist.

4. Speicherzelle gemäß Anspruch 1, dadurch *gekennzeichnet*, daß die genannte schwebende Gate-Elektrode aus einer ersten Schicht (16) polykristallinen Siliziums besteht, und daß die genannten ersten und zweiten Steuerelektroden (24, 26) eine zweite Schicht (20A, 20B) polykristallinen Siliziums aufweisen.

5. Speicherzelle gemäß Anspruch 1, dadurch *gekennzeichnet*, daß die genannte Wortleitungs-Elektrode (22) aus einer Schicht polykristallinen Siliziums besteht.

6. Speicherzelle gemäß Anspruch 1, dadurch *gekennzeichnet*, daß jedes der genannten ersten und zweiten Ladungsträger-Injektionsmittel (20A, 20B) eine elektrische Charakteristik aufweist, die derjenigen von zwei gegeneinandergeschalteten Dioden entspricht.

7. Speicherzelle gemäß Anspruch 6, dadurch *gekennzeichnet*, daß jedes der genannten Ladungsträger-Injektionsmittel eine Schicht eines Doppel-Elektroneninjektionsstruktur-Materials aufweist, das durch Ätzen zwei getrennte Zonen (20A, 20B) bildet.

8. Speicherzelle gemäß Anspruch 1, *gekennzeichnet* durch eine Speicherplatten-Elektrode (26), die isoliert auf dem Halbleitersubstrat (10, 12) angeordnet ist und wenigstens teilweise die genannte erste Zone (10) überdeckt.

9. Speicherzelle gemäß Anspruch 8, dadurch *gekennzeichnet*, daß die Speicherplatten-Elektrode (26) und eine der ersten und zweiten Steuerelektroden (24,26) elektrisch miteinander verbunden sind.

10. Speicherzelle gemäß Anspruch 1, dadurch *gekennzeichnet*, daß die genannten ersten und zweiten Steuerelektroden (24, 26) erste und zweite Steuersignale ($V_{CG}$, $V_P$) erhalten, daß die erste Steuerelektrode (24) Ladung von dem genannten nichtflüchtigen Speicher (16) abführt, wenn die genannte erste Zone (10) des Substrats (10, 12) eine erste, einen ersten logischen Zustand repräsentierende Spannung speichert, und die zweite Steuerelektrode (26) Ladung in den genannten nichtflüchtigen Speicher (16) injiziert, wenn die genannte erste Zone (10) des Substrats (10, 12) eine zweite, einen zweiten logischen Zustand repräsentierende Spannung speichert.

**FIG. 1**

1 / 1

**FIG. 2A**

**FIG. 2B**

**FIG. 3**